# EUROPEAN PATENT APPLICATION

(11) **EP 4 654 469 A2**
(43) Date of publication of application: **26.11.2025**
(21) Application number: 25202285.0
(22) Date of filing: 15.09.2025
(51) Int. Cl.: H03B 5/12, H03B 5/14

(54) **SERIES RESONANCE OSCILLATOR**

(71) Applicant: NXP B.V., 5656 AG Eindhoven (NL); University Of Twente, 7522 NB Enschede (NL)
(72) Inventor: PETRICEVIC, Danilo, 5656AG Eindhoven (NL); KLUMPERINK, Eric, 5656AG Eindhoven (NL); VERLINDEN, Jos, 5656AG Eindhoven (NL); NAUTA, Bram, 5656AG Eindhoven (NL)
(74) Representative: Hardingham, Christopher Mark

(57) **Abstract**

One example discloses an ***oscillator circuit,*** including: *a **first stage,*** including: a first LC tank configured to output a first voltage; a first V-I converter, coupled to receive and convert the first voltage from the first LC tank into a first current; and a first current comparator, coupled to receive and convert the first current from the V-I converter into a second voltage; and a ***second stage*** coupled to receive and convert the second voltage from the first stage into a third voltage; wherein the first LC tank is configured to receive and convert the third voltage into the first voltage.

## Description

The present specification relates to systems, methods, apparatuses, devices, articles of manufacture and instructions for low-phase noise series resonance oscillators.

### SUMMARY

According to an example embodiment, an *oscillator circuit,* comprising: *a first stage,* including: a first LC tank configured to output a first voltage; a first V-I converter, coupled to receive and convert the first voltage from the first LC tank into a first current; and a first current comparator, coupled to receive and convert the first current from the V-I converter into a second voltage; and a *second stage* coupled to receive and convert the second voltage from the first stage into a third voltage; wherein the first LC tank is configured to receive and convert the third voltage into the first voltage.

In another example embodiment, the oscillator circuit is ***a series resonance oscillator** circuit.*

In another example embodiment, the ***first stage*** is configured to phase shift the second voltage 180° from the third voltage.

In another example embodiment, the ***second stage*** is configured to phase shift the third voltage 180° from the second voltage.

In another example embodiment, the ***first LC tank*** is configured to phase shift the first voltage 90° from the third voltage.

In another example embodiment, the ***first V-I converter*** is configured to phase shift the first current 90° from the first voltage.

In another example embodiment, the second stage includes, a second LC tank configured to output a fourth voltage; a second V-I converter, coupled to receive and convert the fourth voltage from the first LC tank into a second current; and a second current comparator, coupled to receive and convert the second current from the V-I converter into the third voltage.

In another example embodiment, the ***second LC tank*** is configured to phase shift the fourth voltage 90° from the second voltage.

In another example embodiment, the ***second V-I converter*** is configured to phase shift the second current 90° from the fourth voltage.

In another example embodiment, the first LC tank and the second LC tank each include an inductor, or a high-Q inductor, (L) and a capacitor (C).

In another example embodiment, the first V-I converter and the second V-I converter are ***capacitive*** V-I converters.

In another example embodiment, the ***capacitive*** V-I converters include only *a **capacitor.***

In another example embodiment, the first and second current comparators each include, ***a first mosfet*** coupled to ***a second mosfet*** at ***a first node;*** the first node is coupled to ***an input of an inverter;*** the first node is coupled to receive the first current; and ***an output*** of the inverter is coupled to ***a control node*** of the first mosfet, ***a control node*** of the second mosfet, and is coupled to generate the second voltage.

In another example embodiment, the first current comparator and the second current comparator include ***Traff's comparators.***

In another example embodiment, further comprising: *a **compensation path*** including ***a first inductor*** coupled in series with *a **second inductor.***

In another example embodiment, one end of the first inductor is coupled to *a **node between*** the first V-I converter and the first current comparator.

In another example embodiment, one end of the second inductor is coupled to *a **node between*** the second V-I converter and the second current comparator.

In another example embodiment, the compensation path includes *a **capacitor*** coupled between the first inductor and the second inductor.

In another example embodiment, the capacitor is a tunable capacitor.

In another example embodiment, further comprising: *a **compensation path*** including ***a first inductor*** and *a **first capacitor*** coupled in series to ground in parallel with *a **second inductor*** and ***a second capacitor*** coupled in series to ground.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings.

### BRIEF DESCRIPTION OF THE DRAWINGS

**Figure 1A** represents an example ***parallel*** LC oscillator.
**Figure 1B** represents an example ***series*** LC oscillator.
**Figure** 2A represents an example ***four tank*** series LC oscillator.
**Figure 2B** represents an example tank and its driver circuit.
**Figure 3** represents a ***first*** example ***two tank*** series LC oscillator.
**Figure 4** represents a ***second*** example ***two tank*** series LC oscillator.
**Figure 5** represents a ***third*** example ***two tank*** series LC oscillator.
**Figure 6** represents *a **fourth*** example ***two tank*** series LC oscillator.
**Figure 7** represents a ***fifth*** example ***two tank*** series LC oscillator.
**Figure 8** represents a ***sixth*** example ***two tank*** series LC oscillator.
**Figures 9A** **and** **9B** respectively represent an example graph of simulated ***phase noise vs. frequency*** and an example graph of simulated ***current consumption vs. time*** for one or more of the example two tank series LC oscillators.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

### DETAILED DESCRIPTION

Ultra-low phase noise clocks with integrated jitter in the sub-pico-second range are needed to meet the stringent speed and resolution requirements in modern wireline and wireless systems.

Phase Locked Loops (PLLs) are the most often used architecture for generating these clocks. The PLLs utilize low phase noise oscillators to reach the ultra-low phase noise requirements.

Series resonance oscillators have a low ohmic impedance at resonance, a good Figure of Merit (FoM), and can achieve such ultra-low phase noise levels; however, they also have a small tunning range, relatively high power consumption, high complexity, require a large silicon area, and have reliability limitations.

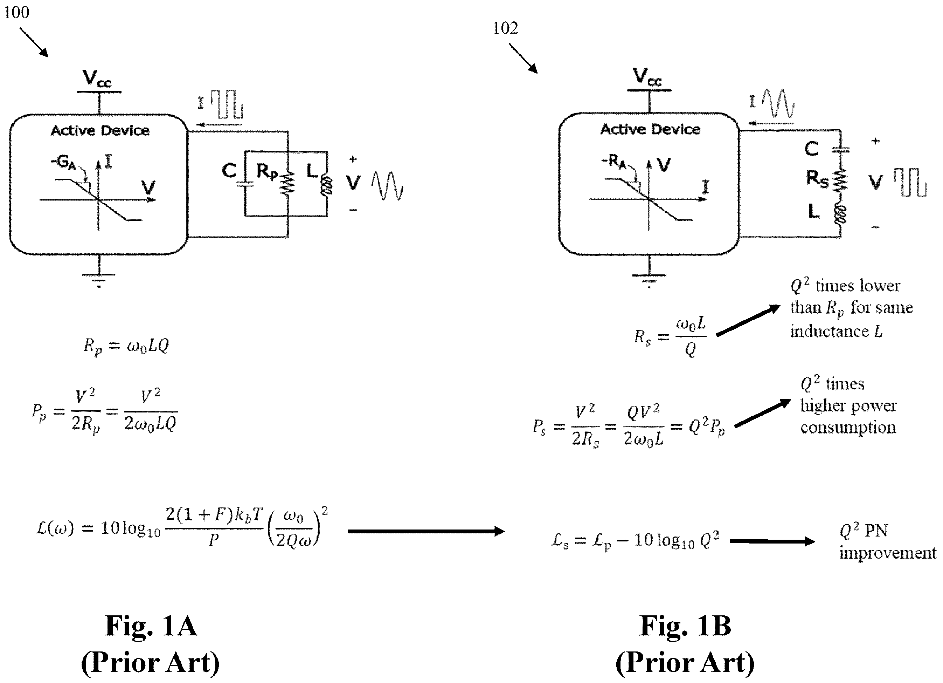

**Figure 1A** represents an example 100 ***parallel*** LC oscillator. The parallel LC oscillator includes *a **parallel combination*** of inductor (L) and capacitor (C) as a parallel LC tank circuit configured to generate oscillations at its resonance.

While different topologies of parallel LC oscillators have been proposed, and although they are able to achieve low phase noise level, their performance is mainly limited by the parallel LC tank quality factor (Q) and excess noise from the active devices.

Since the Q of the tank is technology dependent, and excess noise depends on the topology, the only way to push the phase noise level even further is by burning more power in the tank. This is possible by scaling down the tank impedance.

However, as the tank impedance is scaled down, the inductance value also drops, thus degrading the Q factor and thus limiting phase noise reduction. Therefore, parallel LC oscillator topologies have a limit in how far they can push the phase noise performance, even if the large power consumption is allowed.

**Figure 1B** represents an example 102 ***series*** LC oscillator. The series LC oscillator includes an inductor and a capacitor connected ***in series,*** rather than in parallel. A series LC tank is thus inherently Q² more low-ohmic than a parallel LC tank.

The series LC oscillator allows for a higher power consumption and reduced inductor Q degradation, such that ultra-low phase noise levels can be reached. Some series LC oscillators are able to reach ultra-low phase noise levels using CMOS technology (e.g. < -150 dBc/Hz @ 10 MHz offset oscillating at 10 GHz). In **Figures 1A and 1B****,** "P" represents power consumption, and subscripts "p" and "s" respectively refer to either the parallel topology or the series topology.

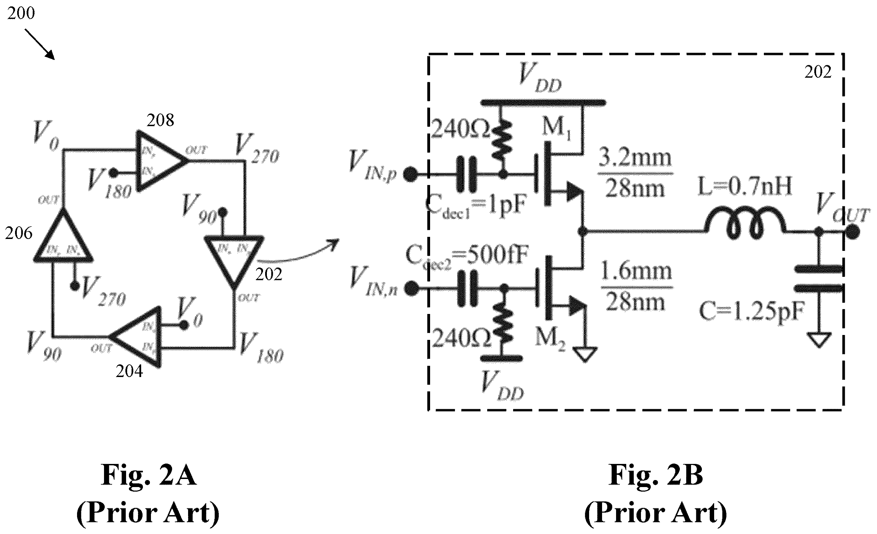

**Figure 2A** represents an example 200 ***four tank*** series LC oscillator. The example 200 four tank series LC oscillator includes a first tank and driver circuit 202, a second tank and driver circuit 204, a third tank and driver circuit 206, and a fourth tank and driver circuit 208. **Figure 2B** represents an example of the first tank and its driver circuit 202.

To generate sustainable oscillations, these series LC oscillators include four series LC tanks connected in a ring structure with four buffers driving them. Due to the low-ohmic nature of series LC tank, the series LC oscillator results in high power consumption and big voltage swing at the LC tank output, compromising the device reliability and limiting oscillator tuning range. The four tank series LC oscillator's ring structure, also, results in big area and high-complexity layout and routing.

Now discussed are example embodiments of a series resonant oscillator topology having a reduced number of LC tanks (e.g. 2 stages) which effectively lowers their power consumption and requires less silicon area, while simultaneously achieving an ultra-low phase noise performance. These example embodiments may be used in applications including: wireline and wireless systems, radar circuits and chirp generation, etc.

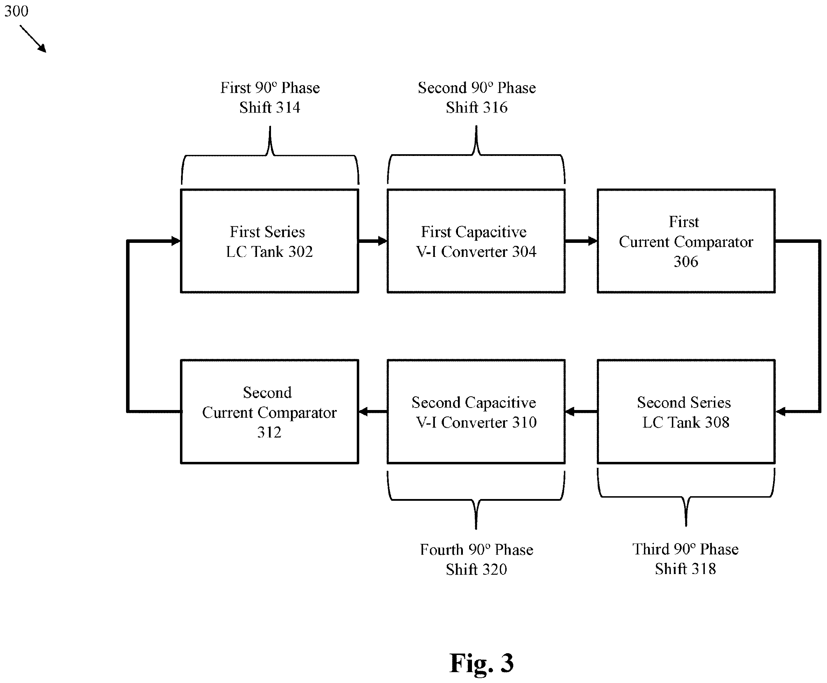

**Figure 3** represents a ***first*** example 300 ***two tank*** series LC oscillator. ***The first*** example ***two tank*** series LC oscillator 300 includes a first series LC tank 302, a first capacitive V-I converter 304, a first current comparator 306, a second series LC tank 308, a second capacitive V-I converter 310, and a second current comparator 312. Together the first series LC tank 302, the first capacitive V-I converter 304, and the first current comparator 306 are defined as a first stage. Together the second series LC tank 308, the second capacitive V-I converter 310, and the second current comparator 312 are defined as a second stage.

The ***two tank*** series LC oscillator 300 achieves 360° phase shift using only two LC tanks 302, 308. Each of the two LC tanks 302, 308 individually produces 90° phase shifts 314, 318. Each of the two capacitive V-I converters 304, 310 also individually produces 90° phase shifts 316, 320. This topology lowers power consumption, silicon area, and circuit complexity, while simultaneously achieving ultra-low phase noise and a good figure of merit (FoM).

The two capacitive V-I converters 304, 310 together produce the additional 180° phase shift from a conversion of a big swing voltage generated by series LC tanks 302, 308 to current. In this way, the ***two tank*** series LC oscillator 300 reuses the big current generated by series LC tanks 302, 308, while simultaneously keeping voltages on active devices inside the technology requirements.

The first and second current comparators 306, 312 then convert the current to a voltage that is fed back into the two LC tanks 302, 308. The first and second current comparators 306, 312 also act as a low-ohmic driver for the series LC tank that follows it.

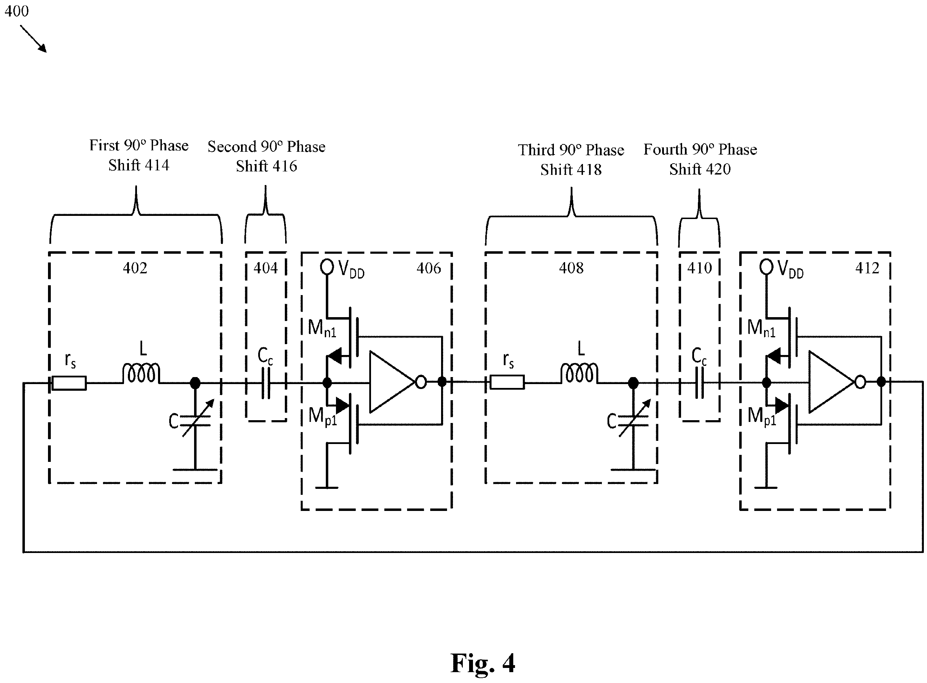

**Figure 4** represents a ***second*** example 400 ***two tank*** series LC oscillator. The ***second*** example ***two tank*** series LC oscillator 400 includes a first series LC tank 402, a first capacitive V-I converter 404, a first current comparator 406, a second series LC tank 408, a second capacitive V-I converter 410, and a second current comparator 412. Together the first series LC tank 402, the first capacitive V-I converter 404, and the first current comparator 406 are defined as a first stage. Together the second series LC tank 408, the second capacitive V-I converter 410, and the second current comparator 412 are defined as a second stage.

The ***two tank*** series LC oscillator 400 achieves 360° phase shift while using only two LC tanks 402, 408. Each of the two LC tanks 402, 408 individually produces 90° phase shifts 414, 418. Each of the two capacitive V-I converters 404, 410 also individually produces 90° phase shifts 416, 420. The ***two tank*** series LC oscillator 400 also lowers power consumption, silicon area, and circuit complexity, while simultaneously achieving ultra-low phase noise and a good figure of merit (FoM).

Each LC tank 402, 408 includes an inductor (L), which is typically or generally a high-Q inductor, and a tunable capacitor (C). The LC tanks 402, 408 oscillate at their resonance frequency (*f_osc*=1/(2*π*√*LC*)) generating the 90° phase shifted 414, 418 high swing voltage.

The two capacitive V-I converters 404, 410 together produce the additional 180° phase shifts 416, 420 from their conversion of the big swing voltages generated by series LC tanks 402, 408 to currents.

The first and second current comparators 406, 412 then convert this current to a voltage that is fed back into the two LC tanks 402, 408. In some example embodiments, the current comparators 406, 412 are implemented as Traff's comparators that read out the current and generate a voltage inversely proportional to the sign of the current. This generated voltage is used to drive the series LC tank in the next stage.

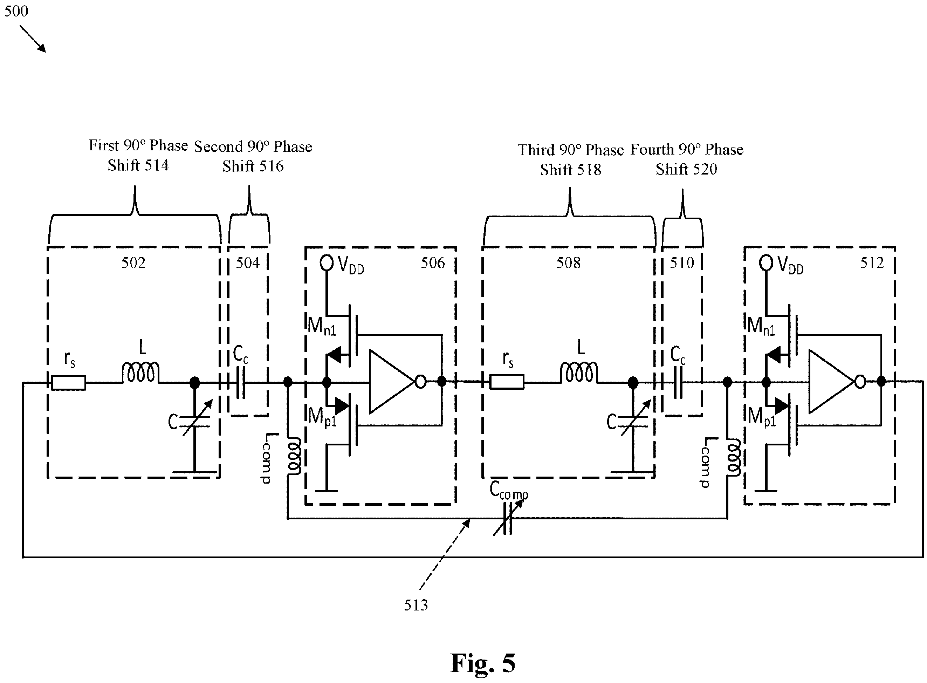

**Figure 5** represents a ***third*** example 500 ***two tank*** series LC oscillator. The ***third*** example ***two tank*** series LC oscillator 500 includes a first series LC tank 502, a first capacitive V-I converter 504, a first current comparator 506, a second series LC tank 508, a second capacitive V-I converter 510, and a second current comparator 512. Together the first series LC tank 502, the first capacitive V-I converter 504, and the first current comparator 506 are defined as a first stage. Together the second series LC tank 508, the second capacitive V-I converter 510, and the second current comparator 512 are defined as a second stage. To cancel parasitic effects and achieve optimal phase noise performance (see discussion below), a compensation path 513 is added.

The ***two tank*** series LC oscillator 500 achieves 360° phase shift while using only two LC tanks 502, 508. Each of the two LC tanks 502, 508 individually produces 90° phase shifts 514, 518. Each of the two capacitive V-I converters 504, 510 also individually produces 90° phase shifts 516, 520. The ***two tank*** series LC oscillator 500 also lowers power consumption, silicon area, and circuit complexity, while simultaneously achieving ultra-low phase noise and a good figure of merit (FoM).

In some example embodiments, additional parasitic phase shifts inside the current comparators 506, 512 could force the two tank series LC oscillator 500 to oscillate away from the resonance frequency of the series LC tanks 502, 508, thus degrading the two tank series LC oscillator's 500 phase noise performance.

The compensation path 513 includes two low-Q compensation inductors (Lcomp) that resonates out any parasitic capacitances at the current comparators 506, 512 input node. The compensation path 513 also includes a tunable capacitor (Ccomp) allowing for optimal compensation across the ***two tank*** series LC oscillator's 500 frequency range.

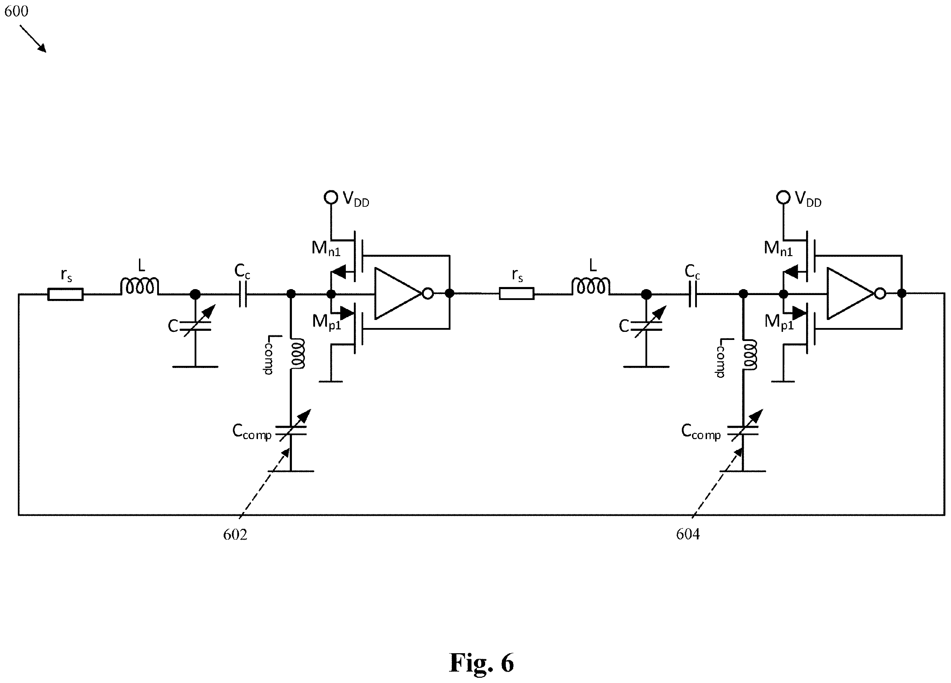

**Figure 6** represents *a **fourth*** example 600 ***two tank*** series LC oscillator. The ***fourth*** example ***two tank*** series LC oscillator 600 is substantially similar to the ***third*** example ***two tank*** series LC oscillator 500, except that the compensation path 513 has been split into two paths 602, 604 having capacitors (Ccomp) coupled to ground.

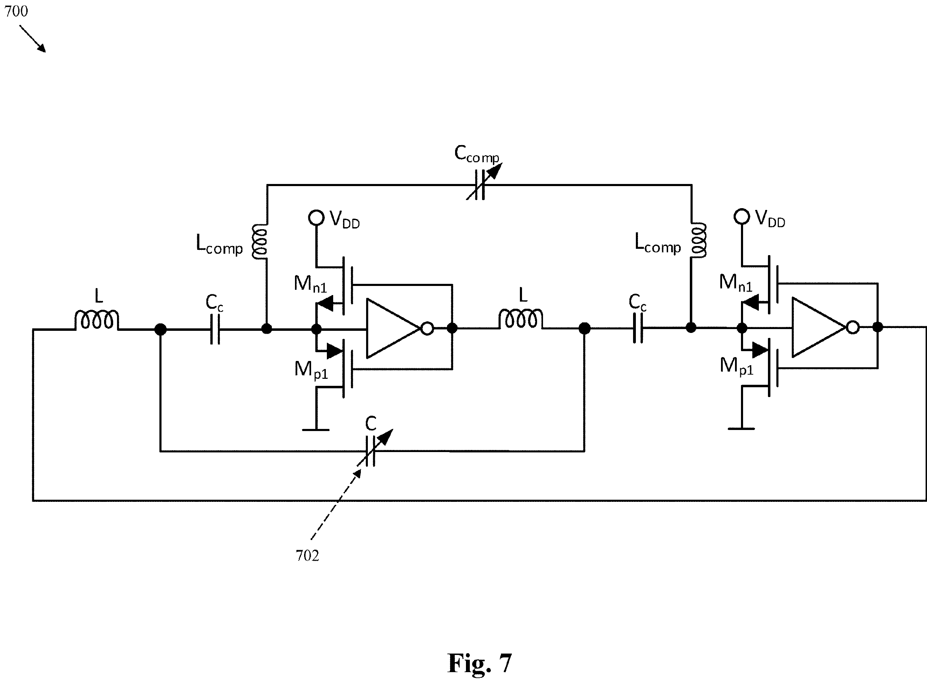

**Figure 7** represents a ***fifth*** example 700 ***two tank*** series LC oscillator. ***The fifth*** example ***two tank*** series LC oscillator 700 is substantially similar to the ***third*** example ***two tank*** series LC oscillator 500, except that two capacitors two ground in the main series LCs (i.e. the one capacitor to ground in the first 90° phase shift 514, and the one capacitor to ground in the third 90° phase shift 518 can be combined in a single capacitor 702 between two inductors (L).

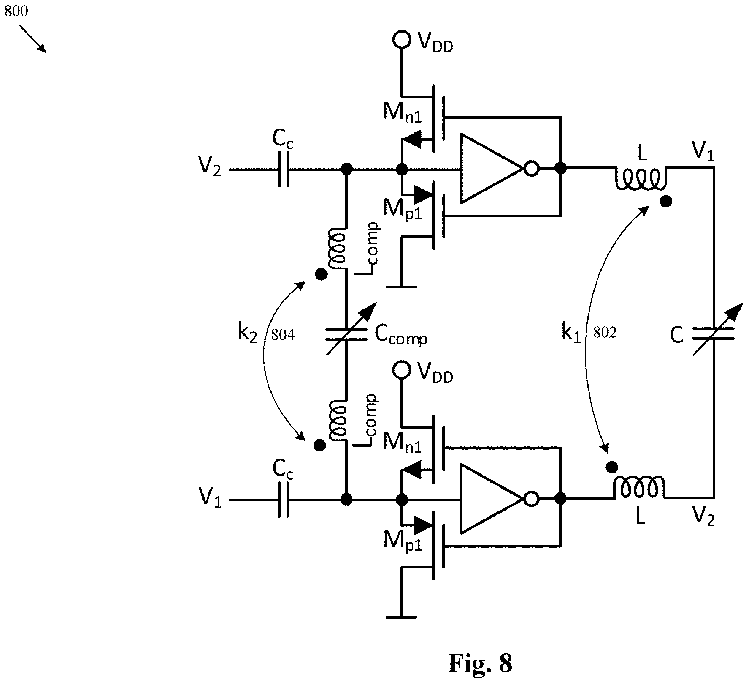

**Figure 8** represents a *sixth* example 800 ***two tank*** series LC oscillator. The ***sixth*** example ***two tank*** series LC oscillator 800 is substantially similar to the ***third*** example ***two tank*** series LC oscillator 500, except that the two inductors (L) are magnetically coupled (k1) 802 to save area and the two compensation inductors (Lcomp) are magnetically coupled (k2) 804 also to save area.

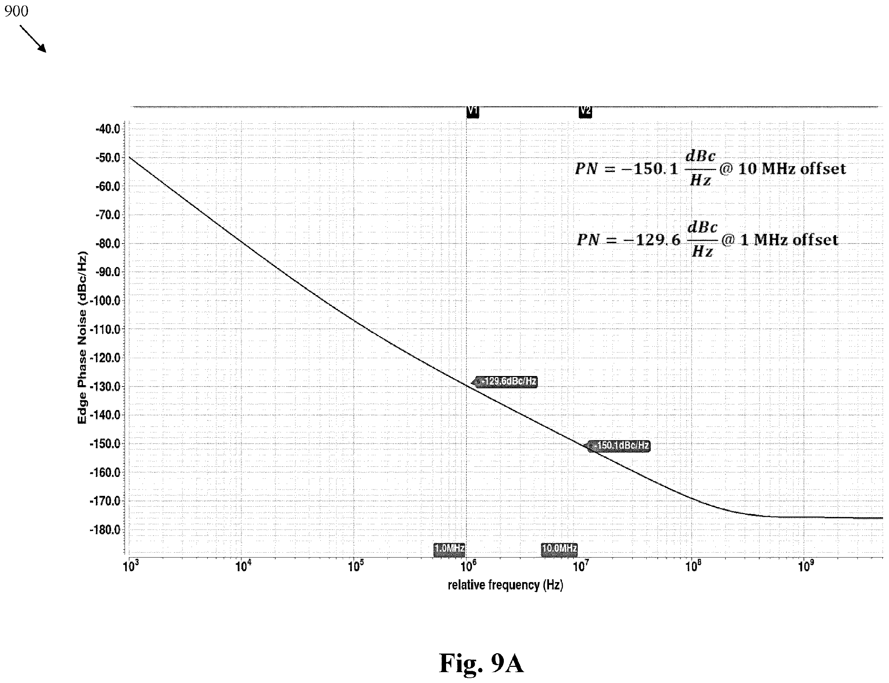

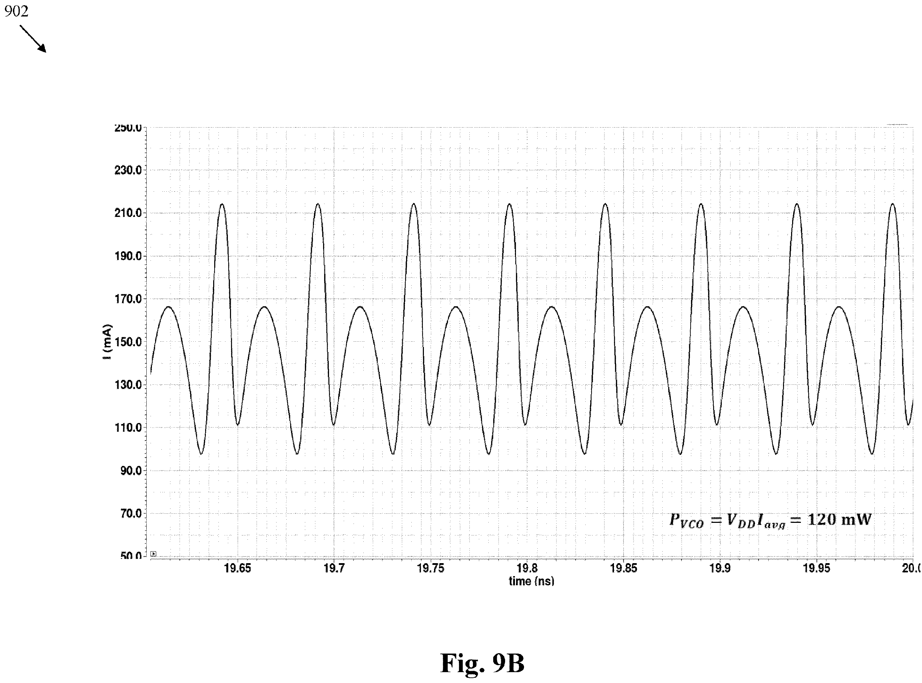

**Figures 9A** **and** **9B** respectively represent an example graph 900 of simulated ***phase noise vs. frequency*** and an example graph 902 of simulated ***current consumption vs.*** time for one or more of the example two tank series LC oscillators 300, 400, 500.

These simulations 900, 902 show that the two tank series LC oscillators 300, 400, 500 can reach ultra-low phase noise levels (<-150 dBc/Hz @ 10 MHz offset oscillating at 10 GHz) while consuming 2.5x less power **than *four tank*** series LC oscillator topology.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

As used herein, ***"predefined"*** is equivalent to ***"predetermined"*** and indicates a value or setting that is tuned for a particular application/embodiment/instance of the described and/or claimed subject matter.

## Claims

1. An ***oscillator circuit,*** comprising:
*a **first stage,*** including:
a first LC tank configured to output a first voltage;
a first V-I converter, coupled to receive and convert the first voltage from the first LC tank into a first current; and
a first current comparator, coupled to receive and convert the first current from the V-I converter into a second voltage; and
*a **second stage*** coupled to receive and convert the second voltage from the first stage into a third voltage;
wherein the first LC tank is configured to receive and convert the third voltage into the first voltage.

2. The oscillator circuit of claim 1:
wherein the oscillator circuit is *a **series resonance oscillator circuit.***

3. The oscillator circuit of claim 1 or 2:
wherein the ***first stage*** is configured to phase shift the second voltage 180° from the third voltage.

4. The oscillator circuit of claim 3:
wherein the ***second stage*** is configured to phase shift the third voltage 180° from the second voltage.

5. The oscillator circuit of claim 1:
wherein the ***first LC tank*** is configured to phase shift the first voltage 90° from the third voltage.

6. The oscillator circuit of claim 5:
wherein the ***first V-I converter*** is configured to phase shift the first current 90° from the first voltage.

7. The oscillator circuit of any preceding claim:
wherein the second stage includes,
a second LC tank configured to output a fourth voltage;
a second V-I converter, coupled to receive and convert the fourth voltage from the first LC tank into a second current; and
a second current comparator, coupled to receive and convert the second current from the V-I converter into the third voltage.

8. The oscillator circuit of claim 7:
wherein the ***second LC tank*** is configured to phase shift the fourth voltage 90° from the second voltage.

9. The oscillator circuit of claim 8:
wherein the ***second V-I converter*** is configured to phase shift the second current 90° from the fourth voltage.

10. The oscillator circuit of any of claims 7 to 9:
wherein the first LC tank and the second LC tank each include a high-Q inductor (L) and a capacitor (C).

11. The oscillator circuit of any of claims 7 to 19:
wherein the first V-I converter and the second V-I converter are ***capacitive*** V-I converters.

12. The oscillator circuit of claim 11:
wherein the ***capacitive*** V-I converters include only ***a capacitor.***

13. The oscillator circuit of any of claims 7 to 12:
wherein the first and second current comparators each include,
***a first mosfet*** coupled to *a **second mosfet*** at ***a first node;***
wherein the first node is coupled to ***an input of an inverter;***
wherein the first node is coupled to receive the first current; and
wherein ***an output*** of the inverter is coupled to *a **control node*** of the first mosfet, *a **control node*** of the second mosfet, and is coupled to generate the second voltage.

14. The oscillator circuit of any of claims 7 to 13:
wherein the first current comparator and the second current comparator include ***Traff's comparators.***

15. The oscillator circuit of any preceding claim, further comprising:
***a compensation path*** including *a **first inductor*** coupled in series with *a **second inductor.***
